# FASCICULE DE BREVET EUROPEEN

(11) **EP 2 188 641 B1**
(45) Date de publication et mention de la délivrance du brevet: **23.03.2011**
(21) Numéro de dépôt: 08807023.0
(22) Date de dépôt: 09.09.2008
(51) Int. Cl.: G01R 15/18

(54) **DISPOSITIF DE MESURE DE L'INTENSITE D'UN COURANT ELECTRIQUE ET APPAREIL ELECTRIQUE COMPORTANT UN TEL DISPOSITIF**
VORRICHTUNG ZUR MESSUNG DER INTENSITÄT EINES ELEKTRISCHEN STROMS UND ELEKTROGERÄT MIT DERARTIGER VORRICHTUNG
DEVICE FOR MEASURING THE INTENSITY OF AN ELECTRIC CURRENT AND ELECTRIC APPLIANCE INCLUDING SUCH DEVICE

(30) Priorité: 10.09.2007 FR 0706309
(43) Date de publication de la demande: 26.05.2010
(73) Titulaire: Socomec S.A., 67230 Benfeld (FR)
(72) Inventeur: KERN, Christian, F-68240 Sigolsheim (FR)
(74) Mandataire: Nithardt, Roland
(86) Numéro de dépôt international: PCT/IB2008/002332
(87) Numéro de publication internationale: WO 2009/034440

(56) Documents cités:
- EP-A- 0 438 616
- EP-A- 0 519 804
- EP-A- 1 074 846
- EP-A- 1 450 176
- WO-A-2005/106506
- DE-A1- 19 606 445
- US-A- 4 980 794
- US-A- 5 453 681

## Description

### Domaine technique:

La présente invention concerne un dispositif de mesure de l'intensité d'un courant électrique, comportant au moins un circuit magnétique disposé à proximité d'un conducteur électrique traversé par un courant à mesurer pour canaliser le champ magnétique induit autour de ce conducteur par le courant à mesurer, au moins une bobine électrique associée audit circuit magnétique pour délivrer une tension proportionnelle à la dérivée de l'intensité du courant à mesurer, et au moins un module de traitement de cette tension pour délivrer une valeur de l'intensité mesurée. L'invention concerne aussi un appareil électrique équipé d'un tel dispositif, cet appareil électrique pouvant être un appareil de coupure du type interrupteur, interrupteur-commutateur, disjoncteur, ou tout autre appareil équivalent, monophasé, polyphasé, avec ou sans neutre.

### Technique antérieure :

Il existe plusieurs types de dispositifs permettant de mesurer l'intensité d'un courant alternatif traversant un conducteur électrique. Les plus connus sont sans doute les transformateurs de courant, qui utilisent un tore magnétique monté sur chaque conducteur électrique formant le primaire du transformateur, et une bobine enroulée autour du tore pour former le secondaire de ce transformateur et délivrer un signal de tension proportionnel à l'intensité mesurée. Néanmoins, ces transformateurs de courant nécessitent une mise en oeuvre particulière. Ils sont relativement encombrants et ont une dynamique de mesure limitée.

D'autres dispositifs utilisent un capteur d'induction de type à effet Hall ou similaire, disposé dans l'entrefer étroit d'un circuit magnétique autour duquel est enroulé le conducteur électrique dans lequel on veut mesurer l'intensité du courant qui le parcourt. Lorsqu'il est traversé par les lignes de champ magnétique induit par le courant à mesurer, ce type de capteur délivre un signal de tension à ses bornes représentatif de l'intensité de ce courant. Néanmoins, ces capteurs d'induction sont particulièrement sensibles aux champs magnétiques environnants ou parasites qui ont pour effet de fausser la mesure d'intensité. On peut pallier à cet inconvénient en augmentant la section du circuit magnétique, mais c'est au détriment de son encombrement. De plus, ce type de capteur à une dynamique de mesure très limitée lorsqu'il est utilisé dans une configuration en boucle ouverte. Cette dynamique peut être notablement améliorée en utilisant une configuration en boucle fermée, où un enroulement de compensation permet d'annuler le champ de l'entrefer, le courant traversant l'enroulement de compensation étant alors l'image du courant primaire. Toutefois, ce type de capteur nécessite une alimentation relativement puissante pour pouvoir fournir le courant de compensation.

D'autres dispositifs utilisent le principe de Rogowski, qui consiste en un bobinage dans l'air placé autour d'un conducteur électrique traversé par un courant à mesurer, ce bobinage pouvant être formé d'une ou de plusieurs bobines électriques raccordées en série. L'absence de noyau magnétique risquant d'être saturé autorise une large dynamique de mesure. Néanmoins, la réalisation industrielle des bobines de Rogowski de bonne qualité est très complexe, onéreuse et difficilement reproductible, car ces bobines nécessitent une densité linéique de spires constante ainsi qu'une section de spires constante. De plus, la réalisation d'un dispositif de mesure ouvrant, c'est à dire réalisé en deux parties pour faciliter sa mise en place autour d'un conducteur électrique existant, est également délicate, la régularité du bobinage étant un élément essentiel à la qualité d'un tel dispositif.

D'autres dispositifs encore, comme ceux décrits dans les publications EP 0 438 616 et EP 1 450 176 fournissent une mesure de l'intensité par une mesure du champ magnétique ponctuel dans l'entrefer étroit d'un circuit magnétique de forte épaisseur.
En outre DE 196 06 445 A1 et EP 1 074 846 montrent des capteurs de courant.

Il ressort de cet état de la technique qu'aucun dispositif connu pour mesurer l'intensité d'un courant ne présente une configuration lui permettant de s'intégrer dans l'encombrement réduit d'un appareil électrique standardisé, tel qu'un appareil de coupure. Dans ce type d'application, l'intervalle disponible entre les conducteurs électriques qui entrent et sortent de l'appareil est relativement faible, par exemple de l'ordre de 15 à 30mm, rendant impossible la mise en place des dispositifs de mesure existants sur chaque conducteur. De plus, la proximité des conducteurs électriques induit obligatoirement des champs parasites qui faussent les mesures. Par ailleurs, les dispositifs connus ont une dynamique de mesure limitée, puisqu'ils sont destinés à une application de mesure spécifique. Ainsi, ils ne peuvent pas être utilisés pour des applications complémentaires de comptage d'énergie et/ou de protection contre les surintensités, pour lesquelles la plage d'intensité mesurée est multipliée par un coefficient de 10 au moins.

### Exposé de l'invention:

La présente invention vise à apporter une solution à ce problème en proposant un dispositif de mesure de l'intensité d'un courant de conception simple, économique, ayant un encombrement réduit pour s'intégrer facilement à tout type d'appareils électriques, offrant une grande dynamique de mesure pour pouvoir être polyvalent et faire aussi bien de la mesure que du comptage d'énergie et/ou de la protection contre les surintensités selon les besoins, ce dispositif étant conçu pour être insensible aux champs parasites ainsi qu'à la position du conducteur électrique à mesurer et pour pouvoir être réalisé en au moins deux parties facilitant sa mise en place.

Dans ce but, l'invention concerne un dispositif de mesure comme décrit dans la revendication 1.

Dans une forme préférée de l'invention, le chemin fermé présente une forme sensiblement en parallélogramme, et le circuit magnétique est formé de deux éléments magnétiques disposés de part et d'autre du conducteur et deux bobines disposées dans l'entrefer des éléments magnétiques de part et d'autre de ce conducteur.

Dans une autre variante de réalisation, le chemin fermé peut présenter une forme sensiblement en polygone, et le circuit magnétique est formé d'un nombre N d'éléments magnétiques disposés autour dudit conducteur et d'un nombre N de bobines disposées dans l'entrefer des éléments magnétiques autour de ce conducteur.

Les bobines sont avantageusement identiques, montées en opposition et raccordées électriquement en série, de sorte que leurs champs utiles s'ajoutent et leurs champs parasites s'annulent. Chaque bobine est réalisée sous la forme d'un circuit imprimé. Dans ce cas, les spires de la bobine sont gravées sur le substrat du circuit imprimé pour former des spires parallèles entre elles, chaque spire comportant au moins un brin supérieur et un brin inférieur rectilignes et parallèles, au moins un des brins de chaque spire comportant un tronçon d'extrémité incliné par rapport audit brin pour relier les spires entre elles. En variante, le dispositif peut comporter un moyen de mesure de la tension par un pont de résistances ou de condensateurs monté sur le circuit imprimé utilisé pour réaliser ladite bobine.

Dans la forme de réalisation préférée, le circuit magnétique est réalisé en matériaux ferromagnétiques à forte perméabilité magnétique, de sorte que le champ magnétique induit par le courant à mesurer soit négligeable dans ledit circuit magnétique par rapport au champ magnétique dans la ou les bobines.

Ce dispositif comporte avantageusement au moins une platine de support sur laquelle sont montés le circuit magnétique et les bobines, cette platine de support comportant au moins une ouverture pour le passage du conducteur et au moins un circuit électrique de liaison pour raccorder les bobines au module de traitement.

De manière préférentielle, ce dispositif est agencé pour mesurer individuellement l'intensité du courant circulant dans plusieurs conducteurs et comporte dans ce cas plusieurs structures de mesure identiques, comportant chacune au moins un circuit magnétique et au moins deux bobines électriques, la platine de support pouvant être commune à l'ensemble des structures de mesure.

Ce dispositif de mesure peut être constitué d'une pièce monobloc au travers de laquelle est enfilé le conducteur, ou avantageusement d'au moins deux pièces assemblées autour du conducteur lors de la mise en place du dispositif dans l'installation électrique.

L'invention concerne également un appareil électrique comme décrit dans la revendication 17.

### Description sommaire des dessins:

La présente invention et ses avantages apparaîtront mieux dans la description suivante de plusieurs modes de réalisation donnés à titre d'exemple non limitatif, en référence aux dessins annexés, dans lesquels :
- la figure 1 représente schématiquement le principe du dispositif de mesure selon l'invention,
- la figure 2 est une vue simplifiée en perspective d'un exemple d'appareil électrique équipé d'un dispositif de mesure selon l'invention,
- la figure 3 est une section du dispositif de mesure de la figure 2,
- la figure 4 est une coupe IV-IV du dispositif de mesure de la figure 3,
- la figure 5 est une vue en perspective d'une partie du dispositif de mesure de la figure 3,
- la figure 6 est une vue en perspective agrandie d'un exemple de bobinage,
   et
- les figures 7A, 7B et 7C sont respectivement des vues de face, de côté et de dessus d'une variante de réalisation d'un dispositif de mesure selon l'invention.

### Illustrations de l'invention:

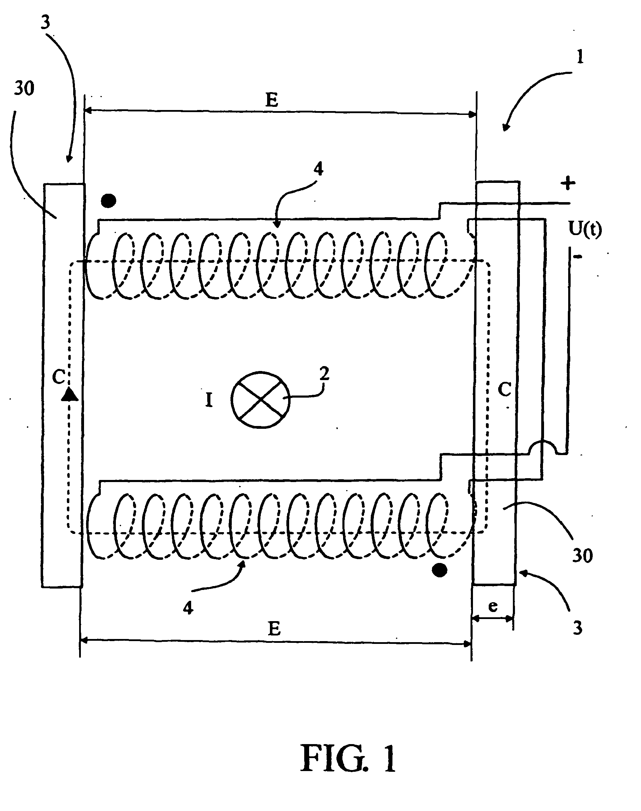

Le principe du dispositif de mesure 1, selon l'invention, permettant de mesurer l'intensité 1 d'un courant traversant un conducteur électrique 2 ou ligne de courant, appelé par la suite conducteur 2, est illustré à la figure 1. Il utilise le champ magnétique induit autour du conducteur 2 par le courant I à mesurer. Dans la présente invention, la circulation des lignes de ce champ magnétique est contrôlée sur un chemin C fermé, formé d'au moins un circuit magnétique 3 ouvert et délimitant au moins deux entrefers E fermés par au moins deux bobines électriques 4, appelées par la suite bobines 4, dont les spires sont orientées perpendiculairement au sens de circulation dudit champ et occupent plus d'un tiers du chemin C fermé. On applique le théorème d'Ampère sur le chemin C en décomposant le champ circulant dans l'air au travers des bobines 4 et le champ circulant dans le circuit magnétique 3. Si l'on choisit un circuit magnétique 3 ayant une perméabilité magnétique élevée, la composante du champ magnétique circulant dans ce circuit magnétique est négligeable par rapport à la composante du champ magnétique circulant dans la bobine 4. De ce fait, la tension aux bornes de la bobine 4 est proportionnelle à la dérivée de l'intensité I du courant à mesurer. C'est donc la qualité du circuit magnétique 3 qui va conditionner les performances du dispositif de mesure 1. Dans ce but, le circuit magnétique 3 est réalisé dans des matériaux ferromagnétiques à forte perméabilité magnétique, tels que les alliages à base de fer, de nickel ou similaire. Ainsi, le circuit magnétique 3 n'est pas utilisé pour concentrer le champ magnétique, mais pour contrôler la distribution de ses lignes de champ et limiter l'influence de ce champ dans les zones non occupées par les bobines 4. On obtient à la fois une optimisation de la réponse de la bobine 4 et un dispositif de mesure 1 insensible aux champs externes parasites.

Dans le dispositif de mesure 1 schématisé à la figure 1, le circuit magnétique 3 est ouvert et comporte deux éléments magnétiques sous forme de plaques 30, planes ou non, sensiblement parallèles, disposées de part et d'autre du conducteur 2, séparées par deux entrefers E larges. Les lignes de champ circulent dans ces plaques 30 en suivant un chemin C sensiblement rectiligne et parallèle auxdites plaques 30. Les entrefers E sont qualifiés de « larges », par opposition aux entrefers « étroits » connus dans les circuits magnétiques habituellement utilisés. Ces entrefers E ont chacun une largeur au moins supérieure au double de l'épaisseur e des plaques 30 et sont suffisamment larges pour y recevoir les bobines 4. Ils peuvent avoir une dimension comprise par exemple entre 15 et 150mm, selon les applications.

Ce dispositif de mesure 1 comporte également deux bobines 4, sensiblement parallèles, disposées de part et d'autre du conducteur 2, et s'étendant à l'intérieur de chaque entrefer E entre les deux plaques 30 pour refermer le chemin C du champ magnétique sans laisser d'espace libre. Les lignes de champ circulent au travers des bobines 4 en suivant un chemin C sensiblement rectiligne et perpendiculaire aux spires desdites bobines. Ces deux bobines 4 sont reliées électriquement en série pour délivrer à leurs bornes une tension de sortie U(t) proportionnelle à la dérivée de l'intensité I du courant à mesurer. Elles sont électriquement identiques, comportent le même nombre de spires et sont enroulées dans des sens opposés pour que les champs utiles s'ajoutent et les champs parasites s'annulent. Le chemin C défini par cette construction a donc sensiblement une forme de parallélogramme.

La sensibilité du dispositif de mesure 1 aux champs parasites et à la position du conducteur électrique 2 est conditionnée par le rapport entre la taille de la surface utile des bobines 4, soit le nombre de spires multiplié par la surface de chaque spire, et la taille des surfaces parasites, en particulier la surface des boucles de retour. Bien que n'importe quelle bobine 4 puisse être utilisée dans l'invention, les bobines 4 réalisées sur des circuits imprimés se prêtent particulièrement bien à cette application. Cette technologie permet en effet un très bon contrôle de la géométrie et de la régularité du bobinage, et réduit considérablement les surfaces parasites au niveau des boucles de retour, grâce à la finesse de gravure qui permet la réalisation de pistes distantes de 0.1mm à 0.2mm.

Etant donné que l'immunité aux champs parasites est obtenue par la construction et la disposition des bobines 4, il est possible de réduire sensiblement la section du circuit magnétique 3, donc l'encombrement global du dispositif de mesure 1. De plus, la présence d'un entrefer E large rend également le dispositif de mesure 1 moins sensible aux variations dimensionnelles de cet entrefer E.

De plus, l'entrefer E large a pour effet de limiter l'induction dans le matériau magnétique et permet par conséquent une dynamique de mesure étendue par rapport aux solutions actuelles à entrefer étroit On obtient ainsi un dispositif de mesure 1 ayant une grande dynamique de mesure qui, s'étend par exemple de 1A à 1600A pour un calibre donné de 63A à 160A, ce qui permet des applications combinées de mesure, de protection et de comptage d'énergie.

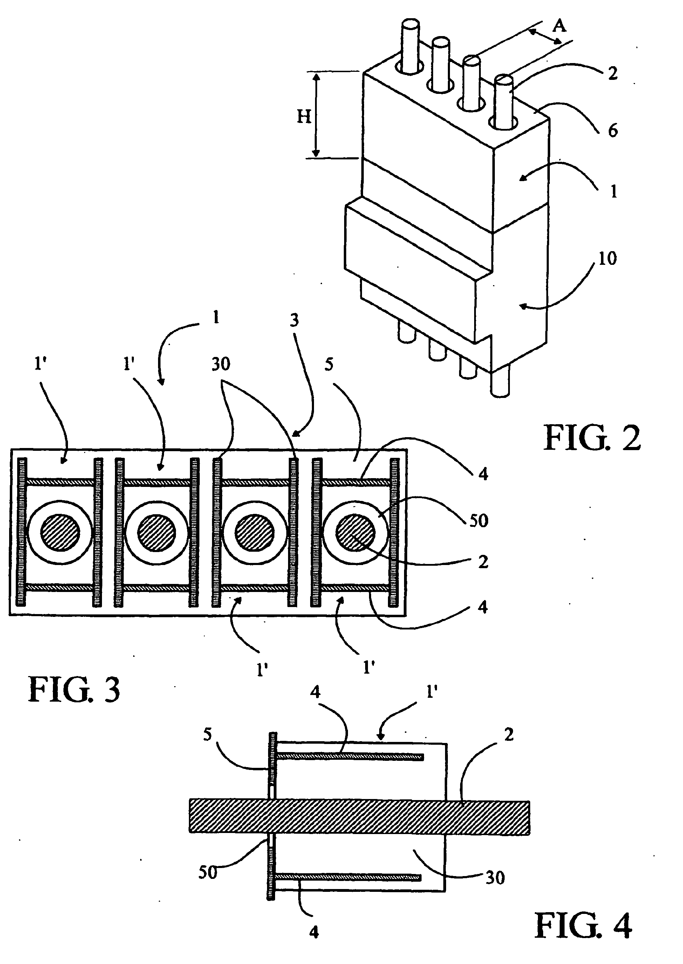

La construction telle que définie ci-dessus permet de réaliser facilement des dispositifs de mesure 1 très étroits et compacts, pouvant s'intégrer parfaitement dans ou sur un appareil électrique 10, dont un exemple est donné en référence aux figures 2 à 4. Selon les besoins, il est possible de proposer les dispositifs de mesure 1 en une version monobloc (en une seule pièce) dans laquelle les conducteurs 2 doivent être enfilés, et en une version démontable (en deux pièces au moins) facilitant son montage sur des conducteurs 2 existants.

Le dispositif de mesure 1 selon l'invention est complété par un module de traitement (non représenté) de la tension de sortie U(t) des bobines 4 en vue de délivrer une valeur de l'intensité I mesurée. Classiquement, ce module de traitement est un intégrateur, auquel on peut ajouter un étage de compensation de phase avec une liaison capacitive pour supprimer l'offset de sortie et le bruit, afin d'en améliorer sa stabilité. Ce module de traitement ou tout autre module équivalent ne fait pas l'objet de la présente invention et ne sera pas détaillé.

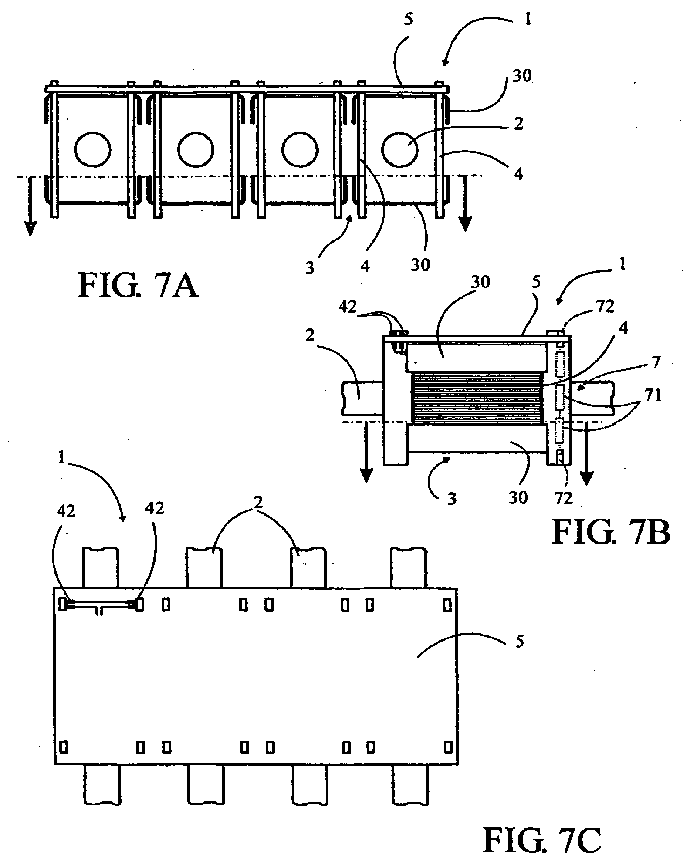

Le dispositif de mesure 1 selon l'invention peut être également complété par un moyen de mesure de la tension 7 aux bornes d'un pont de résistances 71 ou de condensateurs monté sur un circuit imprimé 40 utilisé pour la réalisation des bobines 4 comme expliqué plus loin. On obtient ainsi un capteur combiné intensité/tension avec un même dispositif de mesure 1 (voir représentation en pointillés sur la figure 7B) permettant de mesurer l'intensité du courant traversant le conducteur électrique 2 et simultanément la tension de ce conducteur, dans le but par exemple de réaliser un compteur d'énergie, un transducteur de puissance ou un appareil de contrôle combiné courant/tension utilisé dans la surveillance des réseaux électriques. Le pont de résistances 71 ou de condensateurs est connecté par des plages de connexion 72 d'un côté au module de traitement (non représenté) via la platine de support 5 et de l'autre côté au conducteur 2 lui-même par une liaison filaire (non représentée) ou similaire.

Dans d'autres variantes non représentées, le dispositif de mesure 1 selon l'invention peut comporter un circuit magnétique 3 ouvert présentant d'autres formes, avec plusieurs entrefers E, chaque entrefer étant fermé par une bobine 4, et définissant un chemin C polygonal.

### Meilleure manière de réaliser l'invention :

Les figures 3 à 4 illustrent un exemple préféré du dispositif de mesure 1 selon l'invention, agencé pour se monter dans un appareil électrique 10, comme représenté à la figure 2. Cet appareil électrique 10 peut être un appareil de coupure électrique tel qu'un interrupteur, un interrupteur-commutateur, un disjoncteur ou similaire, mono ou polyphasé, avec ou sans neutre. Dans l'exemple représenté, l'appareil électrique 10 comporte quatre conducteurs 2, dont trois phases et un neutre. L'intervalle A entre deux conducteurs 2 consécutifs est relativement faible; par exemple compris entre 15 et 50mm, selon le type d'appareil, ce qui laisse peut de volume disponible pour placer un dispositif de mesure 1 sur chaque conducteur électrique 2. De même, la hauteur H disponible est limitée par les contraintes de raccordement des conducteurs 2 aux différents circuits ou appareils électrique en amont et/ou en aval, et est par exemple comprise entre 30 et 80mm.

Le dispositif de mesure 1 monté sur l'appareil électrique 10 comporte autant de structures de mesure 1' identiques que de conducteurs 2. Chaque structure 1' de mesure comporte autour de chaque conducteur 2 un chemin C fermé pour la circulation des lignes de champ magnétique, constitué de deux plaques 30 parallèles et de deux bobines 4 disposées dans l'entrefer E, conformément au principe illustré à la figure 1. Chaque structure de mesure 1' est montée sur une platine de support 5, qui comporte des circuits électriques de liaison (non représentées) permettant de raccorder les bobines 4 au module de traitement (non représentée). Cette platine de support 5 comporte des ouvertures 50 formant des passages pour chaque conducteur 2. Ce dispositif de mesure 1 est logé dans un boîtier 6 isolant.

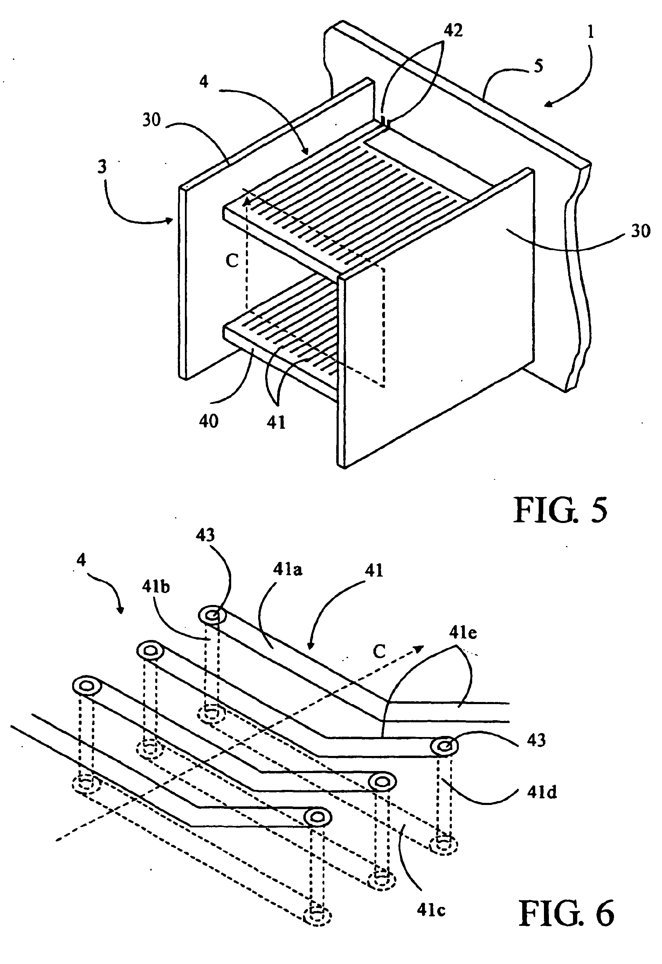

En référence plus particulièrement à la figure 5, chaque bobine 4 est réalisée sous la forme d'un circuit imprimé 40. Elle comporte des spires 41 parallèles entre elles et orthogonales par rapport au chemin C emprunté par les lignes de champ magnétique induit par le courant à mesurer. Les deux bobines électriques 4 sont opposées et connectées en série, comme expliqué précédemment. Le substrat utilisé pour réaliser les circuits imprimés 40 a une faible épaisseur, de l'ordre de 1 à 3mm. L'épaisseur du substrat est choisie de manière à maximiser le ratio entre la densité linéique des spires et cette épaisseur, qui est par exemple égale à 1,6mm pour un circuit imprimé réalisé avec une technologie standard.

Un exemple de dessin du bobinage des spires 41 est illustré à la figure 6, en mode agrandi et volontairement disproportionné, pour faciliter la compréhension. Chaque spire 41 gravée sur le substrat comporte un brin supérieur 41a rectiligne, une première boucle de retour 41b traversant le substrat au travers d'un premier trou de liaison 43 perpendiculaire au substrat, un brin inférieur 41c rectiligne parallèle au brin supérieur 41a, et une seconde boucle de retour 41d traversant le substrat au travers un second trou de liaison 43 perpendiculaire au substrat. Pour permettre, la réalisation de spires 41 parallèles entre elles, le brin supérieur 41a de chaque spire comporte un tronçon d'extrémité incliné 41e par rapport audit brin, pour commencer sa boucle de retour 41d dans le trou de liaison 43 voisin, et ainsi de suite, les tronçons d'extrémité inclinés 41e étant parallèles entre eux. Bien entendu, d'autres dessins équivalents peuvent également convenir.

Les figures 7A, 7B et 7C illustrent une version « ouvrante » du dispositif de mesure 1 selon l'invention, pour pouvoir se monter sur les conducteurs électriques 3 par emboîtement et non par enfilage, lors de la mise en place du dispositif dans l'installation électrique. Dans cet exemple, la configuration des circuits magnétiques 3 est inversée : les plaques 30 sont parallèles à la platine de support 5, et les bobines 4 perpendiculaires à cette platine. La platine de support 5 portent un premier jeu de plaques 30 ainsi que les bobines 4 qui sont directement raccordées entre elles et aux circuits électriques de liaison prévus sur cette platine 5. Ce dispositif de mesure 1 peut être ouvrant sans aucune difficulté. Il suffit que le second jeu de plaques 30, opposé à la platine de support 5, soit monté sur un partie mobile ou amovible du boîtier 6.

### Possibilités d'application industrielle :

Il ressort clairement de cette description que l'invention permet d'atteindre les buts fixés et qu'elle peut être réalisée industriellement en mettant en oeuvre des techniques de production connues dans le domaine de la fabrication d'accessoires électriques et électroniques.

La présente invention n'est pas limitée aux exemples de réalisation décrits mais s'étend à toute modification et variante évidentes pour un homme du métier tout en restant dans l'étendue de la protection définie dans les revendications annexées.

## Revendications

1. Dispositif de mesure (1) de l'intensité (I) d'un courant électrique, comportant au moins un circuit magnétique (3) disposé à proximité d'un conducteur électrique (2) traversé par un courant à mesurer pour canaliser le champ magnétique induit autour dudit conducteur par le courant à mesurer, au moins une bobine électrique (4) associée audit circuit magnétique (3) pour délivrer une tension proportionnelle à la dérivée de l'intensité (I) du courant à mesurer, et au moins un module de traitement de cette tension pour délivrer une valeur de l'intensité mesurée, ledit circuit magnétique (3) étant ouvert et délimitant au moins deux entrefers (E) larges, chaque entrefer étant fermé par une bobine électrique (4), de sorte que ledit circuit magnétique (3) et lesdites bobines électriques (4) délimitent un chemin (C) fermé pour la circulation dudit champ magnétique, **caractérisé en ce que** lesdites bobines (4) disposées dans lesdits entrefers (E) sont réalisées sous la forme de circuits imprimés (40) comportant des spires (41) gravées sur un substrat parallèles entre elles et perpendiculaires au sens de circulation dudit champ magnétique et **en ce que** lesdites bobines (4) disposées dans lesdits entrefers (E) occupent plus d'un tiers dudit chemin (C) fermé.

2. Dispositif selon la revendication 1, **caractérisé en ce que** ledit chemin (C) fermé présente une forme sensiblement en parallélogramme.

3. Dispositif selon la revendication 2, **caractérisé en ce que** ledit circuit magnétique (3) est formé de deux plaques (30) disposées de part et d'autre dudit conducteur (2) et deux bobines (4) disposées dans l'entrefer (E) desdites plaques de part et d'autre dudit conducteur (2).

4. Dispositif selon la revendication 1, **caractérisé en ce que** ledit chemin (C) fermé présente une forme sensiblement en polygone.

5. Dispositif selon la revendication 4, **caractérisé en ce que** ledit circuit magnétique (3) est formé d'un nombre N de plaques (30) disposées autour dudit conducteur (2) et d'un nombre N de bobines (4) disposées dans l'entrefer (E) desdites plaques autour dudit conducteur (2).

6. Dispositif selon la revendication 3 ou 5, **caractérisé en ce que** lesdites bobines (4) sont identiques, montées en opposition et raccordées électriquement en série, de sorte que leurs champs utiles s'ajoutent et leurs champs parasites s'annulent.

7. Dispositif selon la revendication 1, **caractérisé en ce que** chaque spire (41) desdites bobines (4) comporte au moins un brin supérieur (41a) et un brin inférieur (41c) rectilignes et parallèles, au moins un des brins (41a, 41c) de chaque spire (41) comportant un tronçon d'extrémité incliné (41e) par rapport audit brin pour relier les spires entre elles.

8. Dispositif selon la revendication 1, **caractérisé en ce qu'**il comporte un moyen de mesure de la tension (7) par un pont de résistances (71) ou de condensateurs monté sur ledit circuit imprimé (40) utilisé pour réaliser ladite bobine (4).

9. Dispositif selon la revendication 1, **caractérisé en ce que** ledit entrefer (E) a une largeur au moins supérieure au double de l'épaisseur (e) dudit circuit magnétique (3).

10. Dispositif selon l'une quelconque des revendications précédentes, **caractérisé en ce que** ledit circuit magnétique (3) est réalisé en matériaux ferromagnétiques dont la perméabilité magnétique permet que le champ magnétique induit par le courant à mesurer soit négligeable dans ledit circuit magnétique (3) par rapport au champ magnétique dans lesdites bobines (4).

11. Dispositif selon la revendication 1, **caractérisé en ce qu'**il comporte au moins une platine de support (5) sur laquelle sont montés ledit circuit magnétique (3) et lesdites bobines (4), cette platine de support (5) comportant au moins un circuit électrique de liaison pour raccorder lesdites bobines (4) audit module de traitement

12. Dispositif selon la revendication 11, **caractérise en ce que** ladite platine de support (5) comporte au moins une ouverture (50) pour le passage dudit conducteur (2).

13. Dispositif selon la revendication 11 ou 12, **caractérisé en ce qu'**il est agencé pour mesurer individuellement l'intensité (I) du courant circulant dans plusieurs conducteurs (2) et **en ce qu'**il comporte plusieurs structures de mesure (1') identiques, comportant chacune au moins un circuit magnétique (3) et au moins deux bobines électriques (4).

14. Dispositif selon la revendication 13, **caractérisé en ce qu'**il comporte une platine de support (5) commune auxdites structures de mesure (1').

15. Dispositif selon l'une quelconque des revendications précédentes, **caractérisé en ce qu'**il est constitué d'une pièce monobloc au travers de laquelle est enfilé ledit conducteur (2).

16. Dispositif selon l'une quelconque des revendications 1 à 14, **caractérisé en ce qu'**il est constitué d'au moins deux pièces assemblées autour dudit conducteur (2).

17. Appareil électrique (10) alimenté par au moins deux conducteurs électriques (2), **caractérisé en ce qu'**il comporte au moins un dispositif de mesure (1) selon l'une quelconque des revendications précédentes.

## Claims

1. A device (1) for measuring the intensity (I) of an electric current comprising at least one magnetic circuit (3) located near an electric conductor (2) traversed by a current to be measured to channel the magnetic field induced around the conductor by the current to be measured, at least one electric coil (4) associated with the magnetic circuit (3) for delivering voltage proportional to the derivative of the intensity (I) of the current to be measured, and at least one voltage processing module to deliver a value of the intensity measured, the magnetic circuit (3) being open and defining at least two wide gaps (E), each gap being closed by an electric coil (4) so that the magnetic circuit (3) and the electric coils (4) define a closed path (C) for circulation of the magnetic field, **characterized in that** said coils (4) disposed in said gaps (E) are made in the form of a printed circuit (40) comprising windings (41) engraved on a substrate parallel to one another and perpendicular to the direction of the circulation of the magnetic field and **in that** said coils (4) disposed in said gaps (E) occupy more than one-third of closed path C.

2. A device according to claim 1 **characterized in that** the closed path (C) is shaped generally like a parallelogram.

3. A device according to claim 2 **characterized in that** the magnetic circuit (3) is formed of two plates (30) located on either side of the conductor (2) and two coils (4) located in the gap (E) of the plates on either side of the conductor (2).

4. A device according to claim 1 **characterized in that** the closed path (C) is shaped generally like a polygon.

5. A device according to claim 4 **characterized in that** the magnetic circuit (3) is closed by a number N of plates (30) disposed around the conductor (2) and by a number N of coils (4) disposed in the gap (E) in the plates around the conductor (2).

6. A device according to claim 3 or 5 **characterized in that** the coils (4) are identical, attached in opposition, and connected electrically in a series so that their useful fields are increased and their parasitic fields are canceled.

7. A device according to claim 1 **characterized in that** each winding (41) of said coils (4) comprises at least one upper line (41a) and one lower line (41c) that are rectilinear and parallel, at least one of the lines (41a, 41c) on each winding (41) comprising an end portion (41e) that is angled relative to the line to connect the windings to one another.

8. A device according to claim 1 **characterized in that** it comprises a means for measuring voltage (7) using a resistance or condenser bridge (71) attached to the printed circuit (40) used to form the coil (4).

9. A device according to claim 1 **characterized in that** the gap (E) is at least twice as wide as the thickness (e) of the magnetic circuit (3).

10. A device according to any one of the preceding claims **characterized in that** the magnetic circuit (3) is made of ferromagnetic material whose high magnetic permeability allows that the magnetic field induced by the current to be measured is negligible inside the magnetic recruit (3) relative to the magnetic field in the coils (4).

11. A device according to claim 1 **characterized in that** it comprises at least one supporting platform (5) to which are attached the magnetic circuit (3) and the coils (4), said supporting platform (5) comprising at least one connecting electric circuit for connecting the coils (4) to the processing module.

12. A device according to claim 11 **characterized in that** said supporting platform (5) comprises at least one opening (50) for the passage of the conductor (2)..

13. A device according to claim 11 or 12 **characterized in that** it is designed to individually measure the intensity (I) of the current circulating in several conductors (2) and **in that** it comprises several identical measurement structures (1') each comprising at least one magnetic circuit (3) and at least two electric coils (4).

14. A device according to claim 13 **characterized in that** it comprises one supporting platform (5) common to the measurement structures (1').

15. A device according to any one of the preceding claims **characterized in that** it consists of a single unit piece through which the conductor (2) is threaded.

16. A device according to any one of claims 1 through 14 **characterized in that** it consists of at least two pieces assembled around the conductor (2).

17. An electric apparatus (10) supplied by at least two electric conductors (2) **characterized in that** it comprises at least one measurement device (1) according to any one of the preceding claims.

## Patentansprüche

1. Vorrichtung (1) zur Messung der Intensität (I) eines elektrischen Stroms, die mindestens einen Magnetkreis (3) beträgt, welcher in der Nähe eines durch einen zu messenden Strom durchlaufenen Leiters (2) angeordnet ist, um das durch den zu messenden Strom um den besagten Leiter herum induzierte Magnetfeld zu kanalisieren, mindestens eine mit dem besagten Magnetkreis (3) assoziierte elektrische Spule (4) um eine zum Differentialquotient der Intensität (I) des zu messenden Stroms proportionale Spannung zu erzeugen, und mindestens ein Modul zur Verarbeitung dieser Spannung um einen Wert der gemessenen Intensität zu generieren, wobei der besagte Magnetkreis (3) offen ist und mindestens zwei breite Luftspalte (E) begrenzt, wobei jeder Luftspalt durch eine elektrische Spule (4) geschlossen wird, so dass der besagte Magnetkreis (3) und die besagten elektrischen Spulen (4) einen geschlossenen Weg (C) für die Zirkulation des besagten Magnetfeldes begrenzen, **dadurch gekennzeichnet, dass** die in den besagten Luftspalten (E) angeordneten besagten Spulen (4) in der Form von gedruckten Schaltungen (40) hergestellt sind, die auf einem Substrat geätzte, unter sich parallele und zur Zirkulationsrichtung des besagten Magnetfeldes quer angeordnete Windungen (41) beträgt, und **dadurch**, dass die in den besagten Luftspalten (E) angeordneten besagten Spulen (4) mehr als ein Drittel des besagten geschlossenen Wegs (C) einnehmen.

2. Vorrichtung nach Anspruch 1, **dadurch gekennzeichnet, dass** der besagte geschlossene Weg (C) merklich die Form eines Parallelogramms aufweist.

3. Vorrichtung nach Anspruch 2, **dadurch gekennzeichnet, dass** der besagte Magnetkreis (3) aus zwei beidseitig des besagten Leiters (2) angeordnete Platten (30) und aus zwei in dem Luftspalt (E) der besagten Platten, beidseitig des besagten Leiters (2) angeordnete Spulen (4) besteht.

4. Vorrichtung nach Anspruch 1, **dadurch gekennzeichnet, dass** der besagte geschlossene Weg (C) merklich die Form eines Polygons aufweist.

5. Vorrichtung nach Anspruch 4, **dadurch gekennzeichnet, dass** der besagte Magnetkreis (3) aus einer Anzahl von N Platten (30), die um den besagten Leiter (2) herum angeordnet sind, und aus seiner Anzahl von N Spulen (4), die in dem Luftspalt (E) der besagten Platten um den besagten Leiter (2) herum angeordnet sind, besteht.

6. Vorrichtung nach Anspruch 3 oder 5, **dadurch gekennzeichnet, dass** die besagten Spulen (4) identisch sind, in Opposition montiert und elektrisch in Serie verbunden sind, so dass sich ihre Nutzfelder addieren und ihre Störfelder annullieren.

7. Vorrichtung nach Anspruch 1, **dadurch gekennzeichnet, dass** jede Windung (41) der besagten Spulen (4) mindestens einen oberen Teil (41a) und einen unteren Teil (41c) beträgt, die geradlinig und parallel sind, wobei mindestens einer der Teile (41a, 41c) jeder Windung (41) einen in Bezug auf den besagten Teil geneigten Endabschnitt (41 e) aufweist, um die Windungen untereinander zu verbinden.

8. Vorrichtung nach Anspruch 1, **dadurch gekennzeichnet, dass** sie ein Mittel zur Messung der Spannung (7) durch eine Widerstands- oder Kondensatorenmessbrücke (71) beträgt, das auf die für die Herstellung der besagten Spule (4) verwendete besagte gedruckte Schaltung (40) montiert ist.

9. Vorrichtung nach Anspruch 1, **dadurch gekennzeichnet, dass** der besagte Luftspalt (E) eine Breite aufweist, die mindestens größer ist, als das Doppelte der Dicke (e) des besagten Magnetkreises (3).

10. Vorrichtung nach irgendeinem der vorhergehenden Ansprüche, **dadurch gekennzeichnet, dass** der besagte Magnetkreis (3) aus ferromagnetischen Materialien hergestellt ist, deren magnetische Permeabilität erlaubt, dass das durch den zu messenden Strom in dem besagten Magnetkreis (3) induzierte Magnetfeld in Bezug auf das Magnetfeld in den besagten Spulen (4) unerheblich ist.

11. Vorrichtung nach Anspruch 1, **dadurch gekennzeichnet, dass** sie mindestens eine Tragplatte (5) beträgt, auf der der besagte Magnetkreis (3) und die besagten Spulen (4) montiert sind, wobei diese Tragplatte (5) mindestens eine Verbindungs-Stromschaltung beträgt um die besagten Spulen (4) mit dem besagten Verarbeitungs-Modul zu verbinden.

12. Vorrichtung nach Anspruch 11, **dadurch gekennzeichnet, dass** die besagte Tragplatte (5) mindestens eine Öffnung (50) für den Durchgang des besagten Leiters (2) beträgt.

13. Vorrichtung nach Anspruch 11 oder 12, **dadurch gekennzeichnet, dass** sie ausgelegt ist, um die Intensität (I) des in mehreren Leitern (2) fließenden Stroms individuell zu messen, und **dadurch**, dass sie mehrere identische Mess-Strukturen (1') beträgt, die jeweils mindestens einen Magnetkreis (3) und mindestens zwei elektrische Spulen (4) betragen.

14. Vorrichtung nach Anspruch 13, **dadurch gekennzeichnet, dass** sie eine den besagten Mess-Strukturen (1') gemeine Tragplatte (5) beträgt.

15. Vorrichtung nach irgendeinem der vorhergehenden Ansprüche, **dadurch gekennzeichnet, dass** sie aus einem einstückigem Teil besteht, durch das der Leiter (2) hindurch geführt wird.

16. Vorrichtung nach irgendeinem der Ansprüche 1 bis 14, **dadurch gekennzeichnet, dass** sie aus mindestens zwei um den besagten Leiter (2) herum zusammengefügte Teile besteht.

17. Durch mindestens zwei Leiter (2) gespeistes Elektrogerät (10), **dadurch gekennzeichnet, dass** es mindestens eine Messvorrichtung (1) nach irgendeinem der vorhergehenden Ansprüche beträgt.
